# EUROPEAN PATENT SPECIFICATION

(11) **EP 3 872 511 B1**
(45) Date of publication and mention of the grant of the patent: **01.11.2023**
(21) Application number: 21156818.3
(22) Date of filing: 12.02.2021
(51) Int. Cl.: G01R 31/52, H02H 1/00

(54) **A NEW TYPE OF ARC FAULT DETECTION DEVICE (AFDD) AND ITS DETECTION METHOD**
NEUER TYP VON LICHTBOGENFEHLERERKENNUNGSVORRICHTUNG UND DETEKTIONSVERFAHREN DAFÜR
NOUVEAU TYPE DE DISPOSITIF DE DÉTECTION DE DÉFAUT D'ARC (AFDD) ET SON PROCÉDÉ DE DÉTECTION

(30) Priority: 28.02.2020 CN 202010131412
(43) Date of publication of application: 01.09.2021
(73) Proprietor: Siemens Aktiengesellschaft, 80333 München (DE)
(72) Inventor: Du, Feng, Shanghai, 200127 (CN); Yi, Xing, Shangai, 200082 (CN); Chen, Wei Gang, Shangai, 200135 (CN); Fu, Ling, Shanghai, 200120 (CN)
(74) Representative: Isarpatent

(56) References cited:
- CN-U- 210 111 945
- US-A1- 2008 204 949
- US-A1- 2009 161 270
- US-A1- 2018 180 671

## Description

### Technical Field

The present invention relates to the field of electric power systems, and in particular to an arc fault detection method and device.

### Background Art

US 2008/204949 A1 describes an arc fault circuit interrupter with separable contacts, a neutral conductor, an operating mechanism structured to open and close the separable contacts, at least one current sensor structured to sense current flowing through the separable contacts and output a sensed current value, and a processor. The processor includes a first routine structured to provide parallel arc fault detection, a second routine structured to provide series arc fault detection, and a third routine structured to enable the first routine and disable the second routine for a predetermined time when the sensed current value is greater than a predetermined value and to enable the second routine and disable the first routine for the predetermined time when the sensed current value is less than the predetermined value.

US 2009/161270 A1 describes an industrial arc fault circuit interrupter and method of detecting arcing conditions.

US 2018/180671 A1 describes a Transistor Resonant Characteristic Sensor (TReCS) with a sensing element positioned along electronic equipment so that the sensing element is electromagnetically coupled to the electronic equipment. The sensing element includes a coil. The sensing element is configured to detect magnetic oscillations associated with a characteristic signal generated by the electronic equipment.

CN 210111945 U describes an arc fault detection system on direct current side of photovoltaic system.

If an arc fault occurs in a circuit system, it would cause huge loss of property and personnel. Therefore, an arc protection device is used in the prior art to effectively avoid an arc fault. However, as the structure of the electric power system becomes increasingly complex, for example, there is a growing number of nonlinear loads and other types of power sources (such as wind power), detection by the existing arc protection device is more difficult. In the prior art, current and voltage characteristics are usually used to identify whether an arc has occurred. However, the arc protection devices of the prior art can hardly detect an electric spark appearing on a circuit, or false tripping occurs due to other characteristics being considered as an arc.

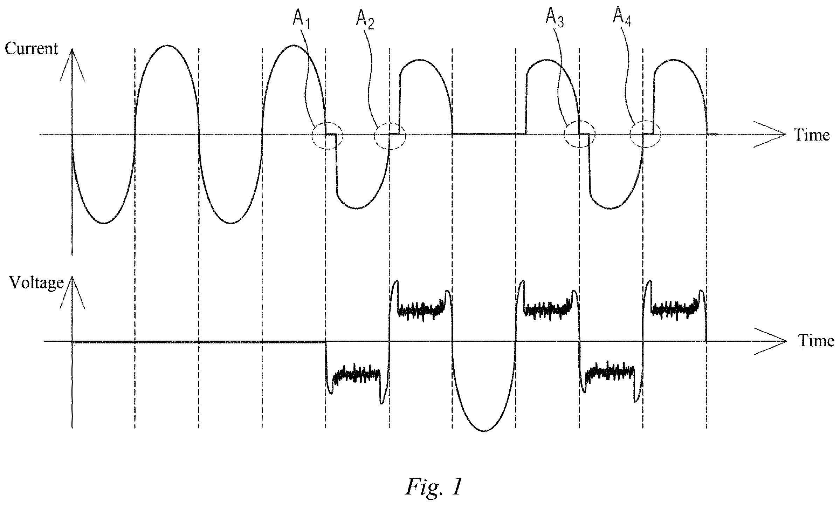

Specifically, the arc protection devices of the prior art generally rely heavily on the determination of senior experts. Specifically, the ordinate of the upper graph of Fig. 1 is current, and the ordinate of the lower graph of Fig. 1 is voltage, with the abscissa being time. As shown in Fig. 1, when an arc fault occurs, voltage changes abruptly, and correspondingly, system current has arc current zero lengths A1, A2, A3, and A4. However, such a case also occurs if there is a nonlinear load in a system, and therefore false determinations will be made.

Optionally, the arc protection device of the prior art also uses high-frequency power and its stability to determine an arc fault, and avoids performing high-frequency sampling on high-frequency signals at the same time. However, only considering high-frequency characteristics cannot fully reflect an arc, resulting in a determination error. Moreover, all determinations are based on limited characteristics of an arc fault that occurs on a circuit, and thresholds need to be set manually, which relies on the determination of senior experts, the degree of which is difficult to grasp.

### Summary of the Invention

The present invention provides an arc fault detection device and an arc fault detection method with the features of the independent claims.

Further advantageous embodiments are the subject matter of the dependent claims.

A first aspect of the present invention provides an arc fault detection device as defined in independent claim 1.

Further, the first envelope waveform generator further comprises: a low-pass filter, which selects, from the circuit signals of the first frequency range, current of a first frequency band and sends same to a first amplifier; and the first amplifier, which amplifies circuit signals of the first frequency band.

Further, a first analog-to-digital converter is further connected between the first amplifier and the analysis device, and the first analog-to-digital converter converts the amplified circuit signals of the first frequency band from analog signals to digital signals, and sends them to the analysis device.

Further, the second envelope waveform generator further comprises: a band-pass filter, which selects, from the circuit signals of the second frequency range, current of a second frequency band and sends same to a second amplifier; the second amplifier, which amplifies circuit signals of the first frequency band; and an envelope detector circuit, which generates the second envelope waveform based on the current of the first frequency band.

Further, a second analog-to-digital converter is further connected between the envelope detector circuit and the analysis device, and the second analog-to-digital converter converts the amplified second envelope waveform from an analog signal to a digital signal, and sends same to the analysis device.

Further, the analysis device is a neural network analysis device, which executes a neural network based on an arc fault detection algorithm, to determine, based on the first envelope waveform and the second envelope waveform, whether current in the electric power system line generates an arc fault signal, wherein when arc current is generated in the electric power system line, the analysis device drives the switch device to perform tripping.

A second aspect of the present invention provides an arc fault detection method as defined in independent claim 7.

Further, step S3 further comprises: selecting, from the circuit signals of the first frequency range, current of a first frequency band and sending same to the first amplifier; and amplifying circuit signals of the first frequency band.

Further, after the step of the method, the method further comprises the following step: converting the amplified circuit signals of the first frequency band from analog signals to digital signals. Further, step S4 further comprises: selecting, from the circuit signals of the second frequency range, current of a second frequency band and sending same to the second amplifier; amplifying circuit signals of the first frequency band; and generating the second envelope waveform based on the current of the first frequency band. Further, after the step of generating, the method further comprises the following step: converting the amplified second envelope waveform from an analog signal to a digital signal.

Further, the step of analysis is performed based on a neural network, and the neural network is executed based on an arc fault detection algorithm, to determine, based on the first envelope waveform and the second envelope waveform, whether current in the electric power system line generates an arc fault signal, wherein when arc current is generated in the electric power system line, the analysis device drives the switch device to perform tripping.

The arc fault detection mechanism according to the present invention relies on wavebands of envelope waveforms in original waveforms on the electric power system line as an arc fault detection input, rather than on one or more of the several existing individual characteristics for arc fault detection. Both high-frequency and low-frequency envelope waveforms naturally comprise all possible characteristics of an arc fault. In addition, the present invention does not require high-frequency sampling to capture an envelope waveform, and the envelope waveform is easily recognizable. The present invention uses a neural network instead of a single threshold to identify the cases where there is an arc and where there is no arc. Even if a representation can hardly be made using several individual characteristics, the neural network is very effective in the differentiation of arc waveforms. Preliminary results show that such a neural network can be optimized to achieve finer granularity and higher accuracy, and can be configured by a low-cost MCU.

### Brief Description of the Drawings

Fig. 1 is a diagram of waveforms for arc fault detection based on current and voltage in the prior art;

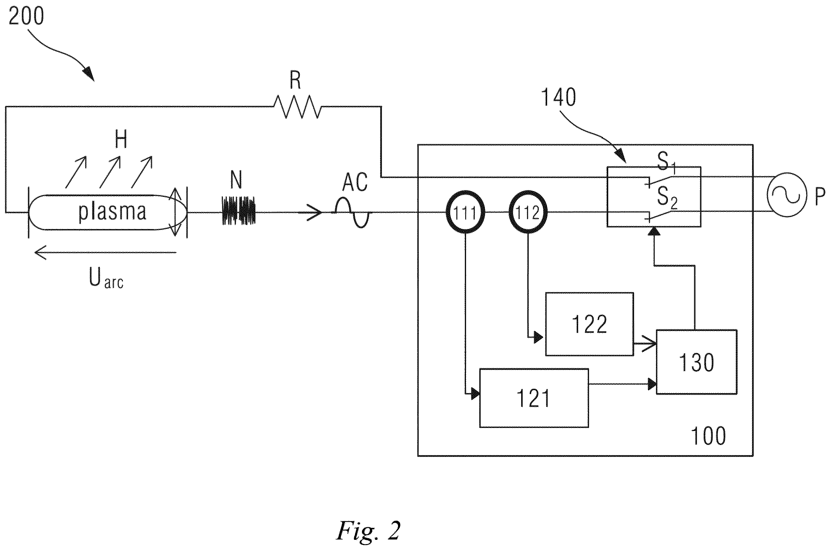

Fig. 2 is a schematic structural diagram of an arc fault detection device according to a specific embodiment of the present invention;
Fig. 3 is a schematic diagram of envelope waveforms in the presence and absence of arc current according to a specific embodiment of the present invention; and
Fig. 4 is a schematic diagram of envelope waveforms in the presence and absence of arc current according to another specific embodiment of the present invention.

### Detailed Description of Embodiments

Specific embodiments of the present invention are described below in conjunction with the accompanying drawings.

An arc fault detection mechanism according to the present invention involves comprehensive analysis and determination directly based on original current in an electric power system line, which avoids the determination performed based only on some factor during generation of arc fault current, and does not rely on the experience of senior experts for determination. Thus, errors and false determinations are avoided, and higher accuracy is provided.

A first aspect of the present invention provides an arc fault detection device 100, which is coupled to a line of an electric power system 200. The electric power system comprises a power source P, which is used to supply power to a load R. However, when arc current is generated in the line, a fault occurs. A circuit signal in the line comprises current and/or voltage, and further comprises heat H, plasma, and noise N. When an arc fault occurs in the line, arc fault current AC and arc fault voltage Uarc are also present in the line.

Specifically, the arc fault detection device 100 comprises a first sensor 111, a second sensor 112, a first envelope waveform generator 121, a second envelope waveform generator 122, and an analysis device 130. The first sensor 111 is connected in series in the electric power system line and collects circuit signals of a first frequency range in the electric power system line. The second sensor 112 is connected in series in the electric power system line and collects circuit signals of a second frequency range in the electric power system line, wherein frequencies in the first frequency range are lower than those in the second frequency range. Preferably, the first sensor 111 is a high-frequency current transformer for collecting high-frequency current. The first sensor 112 is a low-frequency current transformer for collecting low-frequency current. In particular, the first frequency range is tens to hundreds of kHz (kilohertz), and the second frequency range is tens of MHz (megahertz).

The first envelope waveform generator 121 is connected to the first sensor 111, and receives the circuit signals of the first frequency range that are collected by the first sensor 111 and generates a first envelope waveform. In this embodiment, the circuit signal is current. Specifically, the first envelope waveform generator 121 further comprises a low-pass filter and a first amplifier. A first analog-to-digital converter is further connected between the first amplifier and the analysis device, wherein the low-pass filter, the first amplifier, and the first analog-to-digital converter are sequentially connected in series, and the first analog-to-digital converter is connected to the analysis device 130. The low-pass filter selects, from the current of the first frequency range, current of a first frequency band and sends same to the first amplifier. The first amplifier amplifies the current of the first frequency band and sends same to the first analog-to-digital converter. The amplified current signal is an envelope waveform. The analog-to-digital converter converts the amplified current of the first frequency band from an analog signal to a digital signal, and sends same to the analysis device 130. In this embodiment, the first frequency band is 0 kHz to 10 kHz.

The second envelope waveform generator 122 is connected to the second sensor 112, and receives the circuit signals of the second frequency range that are collected by the second sensor 112 and generates a second envelope waveform. Specifically, the second envelope waveform generator further comprises a band-pass filter, a second amplifier, and an envelope detector circuit.

A second analog-to-digital converter is further connected between the envelope detector circuit and the analysis device, and the second analog-to-digital converter converts the amplified second envelope waveform from an analog signal to a digital signal, and sends same to the analysis device 130. The band-pass filter, the second amplifier, the envelope detector circuit, and the second analog-to-digital converter are sequentially connected in series, and the second analog-to-digital converter is connected to the analysis device 130. In addition, the band-pass filter selects, from the current and/or voltage of the second frequency range, current of a second frequency band and sends same to the second amplifier. The second amplifier amplifies the current of the first frequency band. The envelope detector circuit generates the second envelope waveform based on the current and/or voltage of the first frequency band. A second analog-to-digital converter is further connected between the envelope detector circuit and the analysis device 130, and the second analog-to-digital converter converts the amplified second envelope waveform from an analog signal to a digital signal, and sends same to the analysis device 130. In particular, the circuit signal may be current of 100 kHz to 500 kHz, or may be current or voltage of 2 MHz to 23 MHz.

Further, input ends of the analysis device 130 are connected to the first envelope waveform generator 121 and the second envelope waveform generator 122, an output end of the analysis device 130 is coupled to a switch device 140 on the electric power system line, and the analysis device receives the first envelope waveform and the second envelope waveform, and determines, based on the first envelope waveform and the second envelope waveform, whether current in the electric power system line generates an arc fault signal, wherein when an arc fault signal is generated in the electric power system line, the analysis device 130 drives the switch device 140 to perform tripping. The switch device 140 comprises a first switch S₁ and a second switch S₂. The analysis device 130 is a neural network analysis device, which executes a neural network based on an arc fault detection algorithm.

Different from the prior art, the present invention directly uses different low-frequency or high-frequency envelope waveforms as an input to train the algorithm. When a circuit signal is low-frequency, a sampling rate is 20 kHz, which can cover all IEC 62606 detection situations, and the size of a neural network model is reduced to 1.5 MB, with the detection accuracy reaching 99.7%. This fully demonstrates the advantages of the present invention, meaning that the algorithm-based neural network can be used in a low-cost MCU.

The present invention can utilize a deep convolutional neural network, either online or offline. If it is determined that several continuous arc waveforms have occurred, a circuit triggers a tripping action. The present invention can easily detect current with a significantly high frequency envelope waveform. As shown in the figure, in the low-frequency domain, envelope waveforms in the slice groups have a difference in the presence and absence of an arc in the circuit. This is because the current waveform can be affected by interference. However, in the high-frequency domain (for example, in the frequency range of 2 MHz to 23 MHz), envelope waveforms have a difference in the presence and absence of an arc. In addition, due to varying high-frequency noise, simply setting a numerical threshold does not work. In the low-frequency domain (2 MHz to 23 MHz), envelope waveforms in each sliced group have a difference in the presence or absence of an arc, and therefore envelope waveform detection can be used to determine whether an arc fault has occurred.

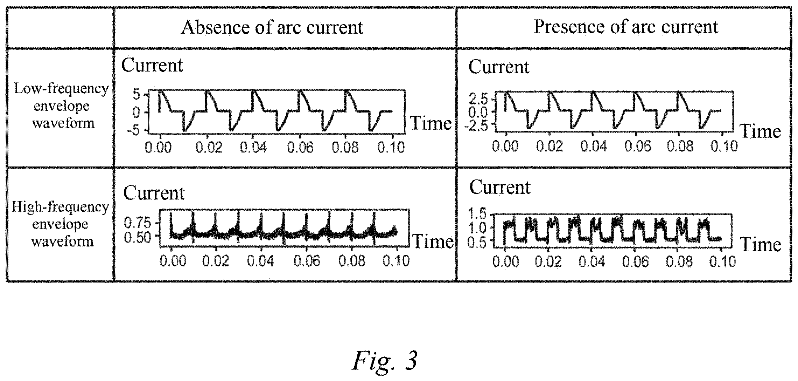

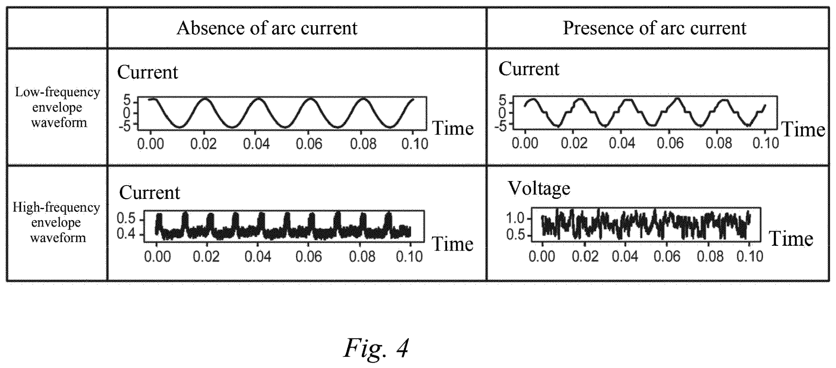

Figs. 3 and 4 are schematic diagrams of envelope waveforms in the presence and absence of arc current, including low-frequency envelope waveforms corresponding to the presence and absence of arc current and high-frequency envelope waveforms corresponding to the presence and absence of arc current. In the waveform diagram in Fig. 3, the abscissa is time, and the ordinate is current. For the low-frequency envelope waveforms, regardless of whether there is arc current, an envelope waveform over each waveband has little difference.

However, for the high-frequency (e.g., 2 MHz to 23 MHz) envelope waveforms, an envelope waveform over each waveband has a very evident difference in the presence and absence of arc current. In addition, in the present invention, due to different high-frequency noise, setting a predetermined threshold does not work.

As shown in Fig. 4, in the waveform diagrams of low-frequency envelope waveforms, the ordinate is current or voltage, and the abscissa is time. In the waveform diagrams of low-frequency envelope waveforms, the ordinate is current or voltage, and the abscissa is time. As shown in the figure, for the low-frequency envelope waveforms, an envelope waveform over each waveband has a very evident difference in the presence and absence of arc current. Similarly, for the high-frequency envelope waveforms, an envelope waveform over each waveband has a very evident difference in the presence and absence of arc current.

A second aspect of the present invention provides an arc fault detection method, the method comprising: S1. collecting circuit signals of a first frequency range in an electric power system line; S2. collecting circuit signals of a second frequency range in the electric power system line, wherein frequencies in the first frequency range are lower than those of the circuit signals of the second frequency range; S3. receiving the circuit signals of the first frequency range that are collected by a first sensor and generating a first envelope waveform; S4. receiving the circuit signals of the second frequency range that are collected by a second sensor and generating a second envelope waveform; and S5. receiving the first envelope waveform and the second envelope waveform, and determining, based on the first envelope waveform and the second envelope waveform, whether current in the electric power system line generates an arc fault signal, wherein when an arc signal is generated in the electric power system line, the analysis device drives the switch device to perform tripping.

Further, step S3 further comprises: selecting, from the circuit signals of the first frequency range, current of a first frequency band and sending same to the first amplifier; and amplifying circuit signals of the first frequency band.

Further, after the step of the method, the method further comprises the following step: converting the amplified circuit signals of the first frequency band from analog signals to digital signals.

Further, step S4 further comprises: selecting, from the circuit signals of the second frequency range, current of a second frequency band and sending same to the second amplifier; amplifying circuit signals of the first frequency band; and generating the second envelope waveform based on the current of the first frequency band.

Further, after the step of generating, the method further comprises the following step: converting the amplified second envelope waveform from an analog signal to a digital signal.

Further, the step of analysis is performed based on a neural network, and the neural network is executed based on an arc fault detection algorithm, to determine, based on the first envelope waveform and the second envelope waveform, whether current in the electric power system line generates an arc fault signal, wherein when arc current is generated in the electric power system line, the analysis device drives the switch device to perform tripping.

The arc fault detection mechanism according to the present invention relies on wavebands of envelope waveforms in original waveforms on the electric power system line as an arc fault detection input, rather than on one or more of the several existing individual characteristics for arc fault detection. Both high-frequency and low-frequency envelope waveforms naturally comprise all possible characteristics of an arc fault. In addition, the present invention does not require high-frequency sampling to capture an envelope waveform, and the envelope waveform is easily recognizable. The present invention uses a neural network instead of a single threshold to identify the cases where there is an arc and where there is no arc.

Even if a representation can hardly be made using several individual characteristics, the neural network is very effective in the differentiation of arc waveforms. Preliminary results show that such a neural network can be optimized to achieve finer granularity and higher accuracy, and can be configured by a low-cost MCU.

Although the content of the present invention has been described in detail through the preferred embodiments above, it should be appreciated that the description above should not be considered as a limitation to the present invention. Various modifications and substitutions to the present invention will be apparent after perusal of the content above by those skilled in the art. Thus, the scope of protection of the present invention should be defined by the appended claims . In addition, any reference sign in the claims should not be construed as limiting the claims involved. The term "comprise" does not exclude other apparatuses or steps not listed in the claims or the specification. The terms "first", "second", etc., are only used to refer to names, and do not denote any particular order.

## Claims

1. An arc fault detection device (100), comprising:
a first sensor (111), which is connectable in series in an electric power system line and which is configured to collect circuit signals of a first frequency range in the electric power system line;
a second sensor (112), which is connectable in series in the electric power system line and which is configured to collect circuit signals of a second frequency range in the electric power system line, wherein frequencies in the first frequency range are lower than those of the circuit signals of the second frequency range;
a first envelope waveform generator (121), which is connected to the first sensor (111), and receives the circuit signals of the first frequency range that are collected by the first sensor (111) and generates a first envelope waveform;
a second envelope waveform generator (122), which is connected to the second sensor (112), and receives the circuit signals of the second frequency range that are collected by the second sensor (112) and generates a second envelope waveform; and
an analysis device (130), with input ends thereof being connected to the first envelope waveform generator and the second envelope waveform generator (122) and an output end of the analysis device (130) configured to be coupled to a switch device (140) on the electric power system line, and the analysis device receiving the first envelope waveform and the second envelope waveform, and determining, based on the first envelope waveform and the second envelope waveform, whether current in the electric power system line generates an arc fault signal, wherein
when an arc signal is generated in the electric power system line, the analysis device (130) drives the switch device (140) to perform tripping,
**characterised in that**
the analysis device (130) is a neural network analysis device, which executes a neural network based on an arc fault detection algorithm.

2. The arc fault detection device (100) as claimed in claim 1, wherein the first envelope waveform generator (121) further comprises:
a low-pass filter, which selects, from the circuit signals of the first frequency range, current of a first frequency band and sends same to a first amplifier; and
the first amplifier, which amplifies circuit signals of the first frequency band.

3. The arc fault detection device (100) as claimed in claim 2, wherein a first analog-to-digital converter is further connected between the first amplifier and the analysis device (130), and the first analog-to-digital converter converts the amplified circuit signals of the first frequency band from analog signals to digital signals, and sends them to the analysis device (130).

4. The arc fault detection device (100) as claimed in claim 1, wherein the second envelope waveform generator (122) further comprises:
a band-pass filter, which selects, from the circuit signals of the second frequency range, current of a second frequency band and sends same to a second amplifier;
the second amplifier, which amplifies circuit signals of the first frequency band; and
an envelope detector circuit, which generates the second envelope waveform based on the current of the first frequency band.

5. The arc fault detection device (100) as claimed in claim 4, wherein a second analog-to-digital converter is further connected between the envelope detector circuit and the analysis device (130), and the second analog-to-digital converter converts the amplified second envelope waveform from an analog signal to a digital signal, and sends same to the analysis device (130).

6. The arc fault detection device (100) as claimed in claim 1, wherein the analysis device (130) executes a neural network based on the arc fault detection algorithm, to determine, based on the first envelope waveform and the second envelope waveform, whether current in the electric power system line generates an arc fault signal, wherein
when arc current is generated in the electric power system line, the analysis device (130) drives the switch device (140) to perform tripping.

7. An arc fault detection method, comprising:
S1. collecting circuit signals of a first frequency range in an electric power system line;
S2. collecting circuit signals of a second frequency range in the electric power system line, wherein frequencies in the first frequency range are lower than those of the circuit signals of the second frequency range;
S3. receiving the circuit signals of the first frequency range that are collected by a first sensor (111) and generating a first envelope waveform;
S4. receiving the circuit signals of the second frequency range that are collected by a second sensor (112) and generating a second envelope waveform; and
S5. receiving the first envelope waveform and the second envelope waveform, and determining, based on the first envelope waveform and the second envelope waveform, whether current in the electric power system line generates an arc fault signal, wherein when an arc signal is generated in the electric power system line, an analysis device (130) drives the switch device (140) to perform tripping,
**characterised in that**
an analysis is performed based on a neural network, and the neural network is executed based on an arc fault detection algorithm.

8. The arc fault detection method as claimed in claim 7, wherein step S3 further comprises:
selecting, from the circuit signals of the first frequency range, current of a first frequency band and sending same to the first amplifier; and
amplifying circuit signals of the first frequency band.

9. The arc fault detection method as claimed in claim 8, wherein after the step of the method, the method further comprises the following step: converting the amplified circuit signals of the first frequency band from analog signals to digital signals.

10. The arc fault detection method as claimed in claim 7, wherein step S4 further comprises:
selecting, from the circuit signals of the second frequency range, current of a second frequency band and sending same to the second amplifier;
amplifying circuit signals of the first frequency band; and
generating the second envelope waveform based on the current of the first frequency band.

11. The arc fault detection method as claimed in claim 10, wherein after the step of generating, the method further comprises the following step: converting the amplified second envelope waveform from an analog signal to a digital signal.

12. The arc fault detection method as claimed in claim 7, wherein the neural network is executed based on the arc fault detection algorithm, to determine, based on the first envelope waveform and the second envelope waveform, whether current in the electric power system line generates an arc fault signal, wherein when arc current is generated in the electric power system line, the analysis device (130) drives the switch device (140) to perform tripping.

## Patentansprüche

1. Lichtbogenfehlererkennungsvorrichtung (100), umfassend:
einen ersten Sensor (111), der in Reihe in einer Stromnetzsystemleitung geschaltet werden kann und der ausgelegt ist zum Sammeln von Schaltungssignalen eines ersten Frequenzbereichs in der Stromnetzsystemleitung;
einen zweiten Sensor (112), der in Reihe in der Stromnetzsystemleitung geschaltet werden kann und der ausgelegt ist zum Sammeln von Schaltungssignalen eines zweiten Frequenzbereichs in der Stromnetzsystemleitung, wobei Frequenzen im ersten Frequenzbereich unter jenen der Schaltungssignale des zweiten Frequenzbereichs liegen;
einen ersten Hüllkurvenwellenformgenerator (121), der an den ersten Sensor (111) angeschlossen ist und die Schaltungssignale des ersten Frequenzbereichs empfängt, die durch den ersten Sensor (111) gesammelt werden, und eine erste Hüllkurvenwellenform generiert;
einen zweiten Hüllkurvenwellenformgenerator (122), der mit dem zweiten Sensor (112) verbunden ist und die Schaltungssignale des zweiten Frequenzbereichs empfängt, die durch den zweiten Sensor (112) gesammelt werden, und eine zweite Hüllkurvenwellenform generiert; und
eine Analysevorrichtung (130), deren Eingangsenden an den ersten Hüllkurvenwellenformgenerator und den zweiten Hüllkurvenwellenformgenerator (122) angeschlossen sind, und wobei ein Ausgangsende der Analysevorrichtung (130) dazu ausgelegt ist, an eine Schaltervorrichtung (140) auf der Stromnetzsystemleitung gekoppelt zu werden, und wobei die Analysevorrichtung die erste Hüllkurvenwellenform und die zweite Hüllkurvenwellenform empfängt, und auf Basis der ersten Hüllkurvenwellenform und der zweiten Hüllkurvenwellenform bestimmt, ob Strom in der Stromnetzsystemleitung ein Lichtbogenfehlersignal generiert, wobei
wenn ein Lichtbogensignal in der Stromnetzsystemleitung generiert wird, die Analysevorrichtung (130) die Schaltervorrichtung (140) ansteuert, ein Auslösen auszuführen,
**dadurch gekennzeichnet, dass** die Analysevorrichtung (130) eine Neuronale-Netzwerk-Analysevorrichtung ist, die ein neuronales Netzwerk auf Basis eines Lichtbogenfehlererkennungsalgorithmus ausführt.

2. Lichtbogenfehlererkennungsvorrichtung (100) nach Anspruch 1, wobei der erste Hüllkurvenwellenformgenerator (121) ferner Folgendes umfasst:
ein Tiefpassfilter, das aus den Schaltungssignalen des ersten Frequenzbereichs Strom eines ersten Frequenzbands wählt und selbigen zu einem ersten Verstärker sendet; und
den ersten Verstärker, der Schaltungssignale des ersten Frequenzbands verstärkt.

3. Lichtbogenfehlererkennungsvorrichtung (100) nach Anspruch 2, wobei ein erster Analog-Digital-Wandler ferner zwischen den ersten Verstärker und die Analysevorrichtung (130) geschaltet ist und der erste Analog-Digital-Wandler die verstärkten Schaltungssignale des ersten Frequenzbands von analogen Signalen zu digitalen Signalen umwandelt und sie zu der Analysevorrichtung (130) sendet.

4. Lichtbogenfehlererkennungsvorrichtung (100) nach Anspruch 1, wobei der zweite Hüllkurvenwellenformgenerator (122) ferner Folgendes umfasst:
ein Bandpassfilter, das aus den Schaltungssignalen des zweiten Frequenzbereichs einen Strom eines zweiten Frequenzbands wählt und selbigen an einen zweiten Verstärker sendet;
den zweiten Verstärker, der Schaltungssignale des ersten Frequenzbands verstärkt; und
eine Hüllkurvendetektorschaltung, die die zweite Hüllkurvenwellenform auf Basis des Stroms des ersten Frequenzbands generiert.

5. Lichtbogenfehlererkennungsvorrichtung (100) nach Anspruch 4, wobei ein zweiter Analog-Digital-Wandler ferner zwischen die Hüllkurvendetektorschaltung und die Analysevorrichtung (130) geschaltet ist und der zweite Analog-Digital-Wandler die verstärkte zweite Hüllkurvenwellenform von einem analogen Signal zu einem digitalen Signal umwandelt und selbiges zu der Analysevorrichtung (130) sendet.

6. Lichtbogenfehlererkennungsvorrichtung (100) nach Anspruch 1, wobei die Analysevorrichtung (130) ein neuronales Netzwerk auf Basis des Lichtbogenfehlererkennungsalgorithmus ausführt, um auf Basis der ersten Hüllkurvenwellenform und der zweiten Hüllkurvenwellenform zu bestimmen, ob Strom in der Stromnetzsystemleitung ein Lichtbogenfehlersignal generiert, wobei
wenn ein Lichtbogenstrom in der Netzstromsystemleitung generiert wird, die Analysevorrichtung (130) die Schaltereinrichtung (140) ansteuert, ein Auslösen auszuführen.

7. Lichtbogenfehlererkennungsverfahren, umfassend:
S1. Sammeln von Schaltungssignalen eines ersten Frequenzbereichs in einer Stromnetzsystemleitung;
S2. Sammeln von Schaltungssignalen eines zweiten Frequenzbereichs in der Stromnetzsystemleitung, wobei Frequenzen in dem ersten Frequenzbereich unter jenen der Schaltungssignale des zweiten Frequenzbereichs liegen;
S3. Empfangen der Schaltungssignale des ersten Frequenzbereichs, die durch einen ersten Sensor (111) gesammelt werden, und Generieren einer ersten Hüllkurvenwellenform;
S4. Empfangen der Schaltungssignale des zweiten Frequenzbereichs, die durch einen zweiten Sensor (112) gesammelt werden, und Generieren einer zweiten Hüllkurvenwellenform; und
S5. Empfangen der ersten Hüllkurvenwellenform und der zweiten Hüllkurvenwellenform und Bestimmen auf Basis der ersten Hüllkurvenwellenform und der zweiten Hüllkurvenwellenform, ob Strom in der Stromnetzsystemleitung ein Lichtbogenfehlersignal generiert, wobei, wenn ein Lichtbogensignal in der Stromnetzsystemleitung generiert wird, eine Analysevorrichtung (130) die Schaltervorrichtung (140) ansteuert, ein Auslösen auszuführen,
**dadurch gekennzeichnet, dass** eine Analyse auf Basis eines neuronalen Netzwerks durchgeführt wird, und das neuronale Netzwerk auf Basis eines Lichtbogenfehlererkennungsalgorithmus ausgeführt wird.

8. Lichtbogenfehlererkennungsverfahren nach Anspruch 7, wobei Schritt S3 ferner Folgendes umfasst:
Wählen, aus den Schaltungssignalen des ersten Frequenzbereichs, von Strom eines ersten Frequenzbands und Senden von selbigem zu dem ersten Verstärker; und
Verstärken von Schaltungssignalen des ersten Frequenzbands.

9. Lichtbogenfehlererkennungsverfahren nach Anspruch 8, wobei, nach dem der Schritt des Verfahrens das Verfahren ferner den folgenden Schritt umfasst: Umwandeln der verstärkten Schaltungssignale des ersten Frequenzbands von analogen Signalen zu digitalen Signalen.

10. Lichtbogenfehlererkennungsverfahren nach Anspruch 7, wobei Schritt S4 ferner Folgendes umfasst:
Wählen, aus den Schaltungssignalen des zweiten Frequenzbereichs, von Strom eines zweiten Frequenzbands und Senden von selbigem zu dem zweiten Verstärker;
Verstärken von Schaltungssignalen des ersten Frequenzbands; und
Generieren der zweiten Hüllkurvenwellenform auf Basis des Stroms des ersten Frequenzbands.

11. Lichtbogenfehlererkennungsverfahren nach Anspruch 10, wobei nach dem Schritt des Generierens das Verfahren ferner den folgenden Schritt umfasst: Umwandeln der verstärkten zweiten Hüllkurvenwellenform von einem analogen Signal zu einem digitalen Signal.

12. Lichtbogenfehlererkennungsverfahren nach Anspruch 7, wobei das neuronale Netzwerk auf Basis des Lichtbogenfehlererkennungsalgorithmus ausgeführt wird, um auf Basis der ersten Hüllkurvenwellenform und der zweiten Hüllkurvenwellenform zu bestimmen, ob ein Strom in der Netzstromsystemleitung ein Lichtbogenfehlersignal generiert, wobei, wenn ein Lichtbogenstrom in der Netzstromsystemleitung generiert wird, die Analysevorrichtung (130) die Schaltervorrichtung (140) ansteuert, ein Auslösen auszuführen.

## Revendications

1. Dispositif de détection de défauts d'arc (100), comprenant :
un premier capteur (111), qui peut être connecté en série dans une ligne de système de puissance électrique et qui est configuré pour collecter des signaux de circuit d'une première plage de fréquences dans la ligne de système de puissance électrique ;
un deuxième capteur (112), qui peut être connecté en série dans la ligne de système de puissance électrique et qui est configuré pour collecter des signaux de circuit d'une deuxième plage de fréquences dans la ligne de système de puissance électrique, des fréquences dans la première plage de fréquences étant inférieures à celles des signaux de circuits de la deuxième plage de fréquences ;
un premier générateur de forme d'onde d'enveloppe (121), qui est connecté au premier capteur (111), et reçoit les signaux de circuit de la première plage de fréquences collectés par le premier capteur (111) et génère une première forme d'onde d'enveloppe ;
un deuxième générateur de forme d'onde d'enveloppe (122), qui est connecté au deuxième capteur (112), et reçoit les signaux de circuit de la deuxième plage de fréquences collectés par le deuxième capteur (112) et génère une deuxième forme d'onde d'enveloppe ; et
un dispositif d'analyse (130), comportant des extrémités d'entrées de celui-ci connectées au premier générateur de forme d'onde d'enveloppe et au deuxième générateur de forme d'onde d'enveloppe (122) et une extrémité de sortie du dispositif d'analyse (130) configurée pour être couplée à un dispositif commutateur (140) sur la ligne de système de puissance électrique, et le dispositif d'analyse recevant la première forme d'onde d'enveloppe et la deuxième forme d'onde d'enveloppe, et déterminant, sur la base de la première forme d'onde d'enveloppe et de la deuxième forme d'onde d'enveloppe, si un courant dans la ligne de système de puissance électrique génère ou non un signal de défauts d'arc,
lorsqu'un signal d'arc est généré dans la ligne de système de puissance électrique, le dispositif d'analyse (130) amène le dispositif de commutation (140) à réaliser un déclenchement,
**caractérisé en ce que**
le dispositif d'analyse (130) est un dispositif d'analyse de réseau neuronal, qui exécute un réseau neuronal sur la base d'un algorithme de détection de défauts d'arc.

2. Dispositif de détection de défauts d'arc (100) selon la revendication 1,
le premier générateur de forme d'onde d'enveloppe (121) comprenant en outre :
un filtre passe-bas, qui sélectionne, à partir des signaux de circuit de la première plage de fréquences, un courant d'une première bande de fréquences et l'envoie à un premier amplificateur ; et
le premier amplificateur, qui amplifie des signaux de circuit de la première bande de fréquences.

3. Dispositif de détection de défauts d'arc (100) selon la revendication 2, un premier convertisseur analogique-numérique étant en outre connecté entre le premier amplificateur et le dispositif d'analyse (130), et le premier convertisseur analogique-numérique convertissant les signaux de circuit amplifiés de la première bande de fréquences de signaux analogiques en signaux numériques, et les envoyant au dispositif d'analyse (130).

4. Dispositif de détection de défauts d'arc (100) selon la revendication 1, le deuxième générateur de forme d'onde d'enveloppe (122) comprenant en outre :
un filtre passe-bande, qui sélectionne, à partir des signaux de circuit de la deuxième plage de fréquences, un courant d'une deuxième bande de fréquences et l'envoie à un deuxième amplificateur ;
le deuxième amplificateur, qui amplifie des signaux de circuit de la première bande de fréquences ; et
un circuit détecteur d'enveloppe, qui génère la deuxième forme d'onde d'enveloppe sur la base du courant de la première bande de fréquences.

5. Dispositif de détection de défauts d'arc (100) selon la revendication 4, un deuxième convertisseur analogique-numérique étant en outre connecté entre le circuit détecteur d'enveloppe et le dispositif d'analyse (130), le deuxième convertisseur analogique-numérique convertissant la deuxième forme d'onde d'enveloppe amplifiée de signal analogique en signal numérique, et l'envoyant au dispositif d'analyse (130).

6. Dispositif de détection de défauts d'arc (100) selon la revendication 1,
le dispositif d'analyse (130) exécutant un réseau neuronal sur la base de l'algorithme de détection de défauts d'arc, pour déterminer, sur la base de la première forme d'onde d'enveloppe et de la deuxième forme d'onde d'envelopper, si un courant dans la ligne de système de puissance électrique génère ou non un signal de défauts d'arc,
lorsqu'un courant d'arc est généré dans la ligne de système de puissance électrique, le dispositif d'analyse (130) amène le dispositif commutateur (140) à réaliser un déclenchement.

7. Procédé de détection de défauts d'arc, comprenant :
S1. la collecte de signaux de circuit d'une première plage de fréquences dans une ligne de système de puissance électrique ;
S2. la collecte de signaux de circuit d'une deuxième plage de fréquences dans la ligne de système de puissance électrique, des fréquences dans la première plage de fréquences étant inférieures à celles des signaux de circuits de la deuxième plage de fréquences ;
S3. la réception des signaux de circuit de la première plage de fréquences qui sont collectés par un premier capteur (111) et la génération d'une première forme d'onde d'enveloppe ;
S4. la réception des signaux de circuit de la deuxième plage de fréquences qui sont collectés par un deuxième capteur (112) et la génération d'une deuxième forme d'onde d'enveloppe ; et
S5. la réception de la première forme d'onde d'enveloppe et de la deuxième forme d'onde d'enveloppe, et la détermination, sur la base de la première forme d'onde d'enveloppe et de la deuxième forme d'onde d'enveloppe, si un courant dans la ligne de système de puissance électrique génère ou non un signal de défauts d'arc, lorsqu'un signal d'arc est généré dans la ligne de système de puissance électrique, un dispositif d'analyse (130) amène le dispositif commutateur (140) à réaliser un déclenchement,
**caractérisé en ce que**
une analyse est réalisée sur la base d'un réseau neuronal, et le réseau neuronal est exécuté sur la base d'un algorithme de détection de défauts d'arc.

8. Procédé de détection de défauts d'arc selon la revendication 7, l'étape S3 comprenant en outre :
la sélection, à partir des signaux de circuit de la première plage de fréquences, d'un courant d'une première bande de fréquences et son envoi au premier amplificateur ; et
l'amplification de signaux de circuit de la première bande de fréquences.

9. Procédé de détection de défauts d'arc selon la revendication 8, après l'étape du procédé, le procédé comprenant en outre l'étape suivante : conversion des signaux de circuit amplifiés de la première bande de fréquences de signaux analogiques en signaux numériques.

10. Procédé de détection de défauts d'arc selon la revendication 7, l'étape S4 comprenant en outre :
la sélection, à partir des signaux de circuit de la deuxième plage de fréquences, d'un courant d'une deuxième bande de fréquences et son envoi au deuxième amplificateur ;
l'amplification de signaux de circuit de la première bande de fréquences ; et
la génération de la deuxième forme d'onde d'enveloppe sur la base du courant de la première bande de fréquences.

11. Procédé de détection de défauts d'arc selon la revendication 10, après l'étape de génération, le procédé comprenant en outre l'étape suivante : conversion de la deuxième forme d'onde d'enveloppe amplifiée de signal analogique en signal numérique.

12. Procédé de détection de défauts d'arc selon la revendication 7, le réseau neuronal étant exécuté sur la base de l'algorithme de détection de défauts d'arc, pour déterminer, sur la base de la première forme d'onde d'enveloppe et de la deuxième forme d'onde d'enveloppe, si un courant dans la ligne de système de puissance électrique génère ou non un signal de défauts d'arc, lorsqu'un courant d'arc est généré dans la ligne de système de puissance électrique, le dispositif d'analyse (130) amène le dispositif commutateur (140) à réaliser un déclenchement.
